**Europäisches Patentamt**

**European Patent Office**

**Office européen des brevets**

(19)

(11) Publication number: **0 116 521**
**A2**

(12) # EUROPEAN PATENT APPLICATION

(21) Application number: **84830013.3**

(22) Date of filing: **17.01.84**

(51) Int. Cl.³: **H 01 L 31/02**
**H 01 L 31/06**

(30) Priority: **17.01.83 IT 1912583**
**14.11.83 IT 4933683**

(43) Date of publication of application:
**22.08.84 Bulletin 84/34**

(84) Designated Contracting States:
**AT BE CH DE FR GB LI LU NL SE**

(71) Applicant: **Gaspare, Maniscalco**
**Via Roma N.52**
**I-90040 San Cipirello (PA)(IT)**

(72) Inventor: **Gaspare, Maniscalco**
**Via Roma N.52**
**I-90040 San Cipirello (PA)(IT)**

(54) **High yielding solar modulus for the transformation, on photovoltaic cells, of a substantially monochromatic radiation in electric energy.**

(57) The above mentioned invention regards a solar modulus (1) of common type photovoltaic cells, connected with usual means (3) of concentration on it of solar radiation. And this so as to allow the nearly total exploitation of incident radiation through the recovery and consevation in its internal parts of the reflected radiation and the transformation of solar energy. And also of the heat dissipated in it, in the emission, by thermic effect, of a disc (8) of material which has a high thermic conductibility a high absorption of solar radiation and a high fusion point.

This emission by thermic effect, is directed to a panel (10) made of one or more photovoltaic cells through a semitransparent filter (9) of selection of the radiation at the characteristic values of activation of the photovoltaic cells.

FIG. 1

-1-

## DESCRIPTION

The following description is attached to the request for a patent for an Industrial Invention entitled: "High Yielding Solar Modulus For The Transformation, On Photovoltaic Cells, Of A Substantially Monocromatic Radiation In Electric Energy", by Mr. Gaspare Maniscalco, who is of Italian nationality and lives in Via Roma, 52, 90040 San Cipirello (Palermo). The designed inventor is Mr. Gaspare Maniscalco. The above was deposited on _____ with the No.

_____

The invention presented here is in reference to a solar modulus of photovoltaic cells connected with usual means of concentration of solar radiation an is structured so as to trasform the radiation in emission by thermic effect, filtered to nearly monochromatic values for a selective absorption which corresponds to the energy threshold, which is characteristic of the chosen photovoltaic cells. The utilization of fhotovoltaic cells for the transformation of energy related to solar radiation to solar radiation in electric energy, is actually being developed according to different experimental directions, whose final common aim is that of

-2-

obtaining yeildings which are superior and constant in ti me and which can produce more favorable unitary costs.

The average efficiency of the most common photovoltaic cells which have directly been exposed to solar radiation in irradiation conditions of $1KW/m^2$ , is only 12-18% for the silicon cells and 16-20% for arseniureted gallium.

These are more costly even if their yeilding is more con stant at higher temperatures, for which, on the contrary, the yielding of the silicon cells decreases rapidly unless adequate systems of cooling are foreseen.

A certain increase in the yielding is obtained by u sing systems of concentration on cells of solar radiation of the following types: for example, parabolic mirror; or oriented flat mirror; or Fresnel lenses. And this allows us to exploit solar radation more completely; and also to obtain temperature values on the exploitable cells through appropriate cooling circuits for the production of vapor, which can be used, in turn, in electric generators and turbines.

The actual limits of efficiency, of the known solutions, must sbstantially lead back to the difficulty of the entire exploitation of solar radiation for the various dispersions and dissipations, particularly in heat, which are genera ted in the cells, and also for the fact that these cells a re characterized by an energetic threshold of the photo voltaic effect. The manifestation of this effect is limited to a band of radiations of equal wave length or immedia tely inferior to such a threshold. The remaining field of radiations therefore results unused.

-3-

The aim of the invention presented here is that of a chieving a modulus of photovoltaic cells structured so as to limit, as much as possible, the dispersion of the inci dent radiation and the dissipation of its energy content in heat. And this is done by exploiting solar radiation as a means for the emission of radiation having thermic origin. Therefore, trasforming the solar radiation band in a band which is substantially included in the infrared field, or in correspondence to wave lengths which are near est to the characteristic value of the energy threshold of the cell. This emission which has a thermic origin, in passing a semitransparent filter,allows the photovoltaic cells to absorb an almost monochromatic radiation of the specific wave length for the activation of these cells.

The general aim of this invention is, therefore, that of achieving a structure which can exploit, almost totally, the energy related to solar radiation. And this through a recovery of solar radiations which are dispersed and dis sipated in heat, and which contribute to the development of the emission, of thermic origin, directed towards the absorption of photovoltaic cells.

These and other aims are still reached by the solar modulus which represents the object of the invention,and which is characterized because it is made up of:

- a support, which is closed and internally hollow and which develops, from a cylindrical base, in a hemisphe rical form which, at the top, presents a trasparent ope ning to the radiation which is in correspondence to the fire of concentrated solar radiation.

-4-

- a flat disc of highly thermic conductible material, of high absorption of solar radiation and of a high fusion point, which is suitable to reach conditions of light emission by thermic effect of the previously mentioned concentrated solar radiation, and which is found in the internal part of the support in correspondence to the diametrical plane of the base of its hemisferical structure.

- a panel made up of one or more common type photovoltaic cells which are placed parallely below the flat disc in correspondence to the base of the support.

- a semitransparent filter, which selects the band of radiation of the wave length and which corresponds to the characteristic energy threshold of the chosen photovoltaic cells, placed between the disc and the panel of photovoltaic cells.

These are common means which are foressen for the cooling of the modulus of the photovoltaic cell panels, and of the semitransparent filter, related to external means which are common for the recovery or for the energy transformation of the heat which is produced.

Further characteristics and advantages of this invention are more evident in the detailed description of an example of a prefered, but not exclusive, achievment, which as carried out in reference to the enclosed drawings, in which:

- figure 1 shows, in vertical section, an example of achievement of a modulus according to this invention.
- figure 2 shows a functional scheme of the modulus seen

-5-

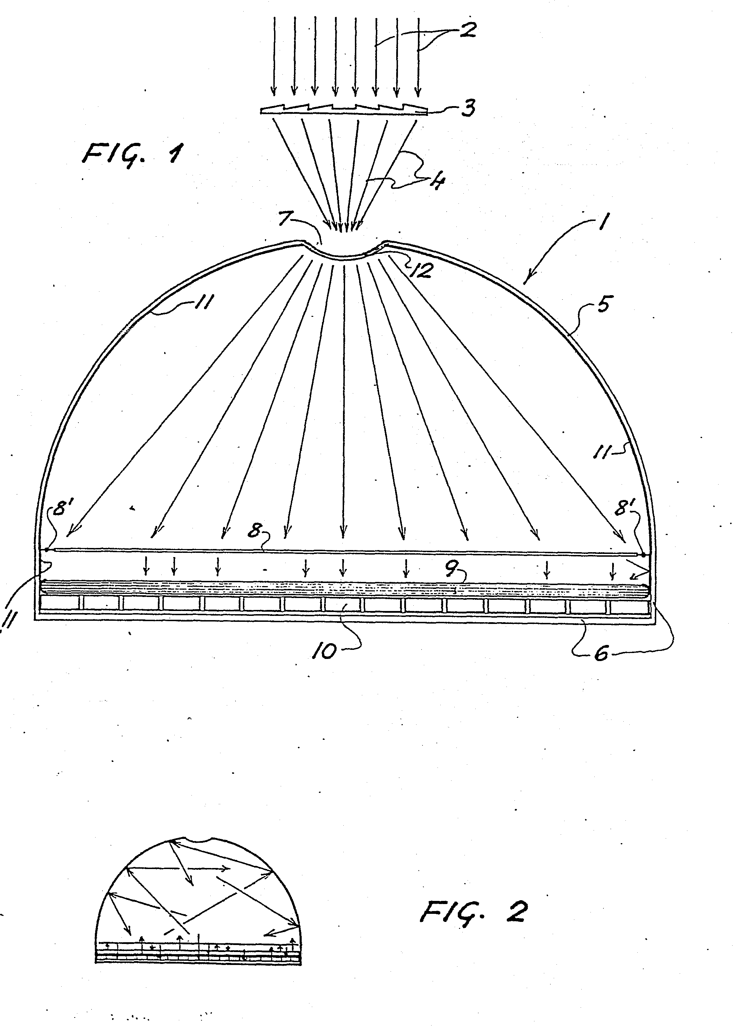

in figure 1.

In reference to the enclosed drawings, 1 indicates, generically, a solar modulus according to the invention, executed as single element or related to a plurality of e qual elements which make up a panel. With 2, the incident solar radiation is indicated, on a conventional means of concentration 3, which is rapresented by a Fresnel lense, whose consequent concentrated solar radiation 4 is directed towards modulus 1.

This modulus 1 is made up of a support 5, which is closed and develops from a substantially cylindrical base 6, in hemispherical form, and which has a transparent o pening 7, at the top, to solar radiation and is in corre spondence to the fire of the mentioned concentrated solar radiation 4.

In the internal part of the support 5, in correspondence to the diametrical base of the hemisperical structure, the re is a disc 8 which is fixed peripherically to the internal walls of support 5, through means of thermoisolated support 8. This disc 8, made of a thin sheet, which can be conti nuous or can be a net of intertwined threads, is made of material which presents high thermic conductibility, high absorption of solar radiation and a high fusion point, sui table to reack conditions of the emission of radiations (in candescence) by thermic effect. this effect is caused by the incidence on it of concentrated solar radiation 4 which is passed through opening 7. The conventiaonal means of con centration 3 allows us to obtain a concentrated radiation 4 suitable , to its fire , to induce remarkable temperature

0116521

-6-

values in the absorption corpora, bringing them easily to incandescence; and therefore ,to the emission of radiations by thermic effect. These are characteristic of the type of material, and which results as belonging to a band sub stantially included in the infrared field, or in correspon dence to the wave length closest to the characteristic vslue of the energy threshold of the photovoltaic cell.

The most suitable materials for the realization of disc 8 may be various, and especially tungsten and its alloys.

Below disc 8 there is a semitrasparent filter 9, of sele ction of the band of radiation which is emitted by the sa me at a value corresponding to the energy threshold of the chosen photovoltaic cell. This filter 9 is made up of a film filter which interferes with a limited passing band in corrispondence to the wave length of the threshold of acti vity of the photovoltaic cell. And this reflects all the ra diation with a longer or shorter wave length of the mentio ned threshold. Below the filter 9, there is a panel 10, which is made up of one or more common type photovoltaic cells.

The photovoltaic cells in use,whether they be the most used silicon ones , or the less used and more expensivs ar seniurereted gallium ones, have the characteristic of absor bing and therefore exploiting only that radiation whose ener gy is equal or superior to a determined energy threshold.

In the case of silicon, it is of 1,1 electron volt which corresponds to a wave length 1,1 micron, included, essential ly, in the infrared field. If we were to directly expose the cell to solar radiation 2 or 4, all the energy related to the radiations of different wave length, would be dispersed.

In the modulus in question, radiation 4 is directed towards disc 8 and is totally exploited for the elevation of temperature, which brings it to emission conditions, prefe rably controled and limited to the infrared field, allows us to direct  the panel of cells 10, a radiation. This radiation is further limited by filter 9, compatible to the limits of absorption of the photovoltaic cell.

The internal surface 11 of the support 5 are made so as to result mirror-like, and so as to reflect totally the ra diations of the entire solar band, and those emitted by  disc 8. And this so as to return on the disc the radiations emitted by it avoiding dispersion (fig.2) and exploiting them, therefore, almost totally for the temperature elevation of the material of this disc. Furthermore, a part of the ra diations is also reflected by filter 9 and a smaller part, on the basis of the limits of selection of the filter and the efficiency of the panel of photovoltaic cells 10, of the sa me cells. Such reflections, because of the specularity of the internal walls 11 of support 5, are dispersed in mini mal part.  Accumulated as they are in support 5, they re turn because of their hemispherical configuration at disc 8, and therefore contribute to elevating its temperature (fig.2).

In an advantageous way, in closed support 5, a forced vacuum with a two-fold aim: That of avoiding rapid oxida tion and deteriorment of the material of disc 8 and that of reducing to its minimum the dispersion of heat by conven tion, is carried out.

The structure of the solar modulus, as has been descri

-8-

bed above, allows us therefore to obtain an almost total ex ploitation of solar radiation, incident in it, limiting at most the dispersion outside of it. The photovoltaic cells concerned by a filtered radiation to their activation values are in i deal conditions of absorption and therefore at maximum yiel ding. This situation eliminates the direct causes of over-hea ting of the cells and therefore of the diminishing of their efficiency. Nonetheless, a cooling circuit suitable for contro ling the maintenence of the bast functioning conditions, is foreseen. Such a cooling circuit, common to more moduli 1 or panels of moduli 1, may be related to an eventual ex ternal circuit of exploitation of the recovered heat, for example, for the production of vapor which can be transfor med in electricity according to conventional systems.

Naturally, that which has been described in only a pre fered, but not exclusive, example of achievement. Various variants are possible, however, they all reenter in the pro tective sphere here claimed.

-9-

CLAIMS

1) Highly yielding solar modulus for the transformation, of photovoltaic cells, of a substantially monochromatic radiation in electric energy, related to common means (3) of concentration of solar radiation (2,) is characterized by the fact that it is made up of:

-a support, which is closed and internally hollow, and which is developed, from a substantially cylindrical base (6) in hemispherical form, with a transparent top opening (7) to radiation, which is in correspondence to the fire of a concentrated solar radiation (4);

-a flat disc (8) made of highly thermic conductible material of high fusion point. It is suitable for the reaching of emission conditions of light for thermic effect of the mentioned concentrated solar radiation (4) And it is placed in the internal part of support (6) in corrispondence to the diametrical plane of the base of its hemispherical structure;

-a panel (10) made up of one or more common type photovoltaic cells, parallely placed and below the flat disc, in correspondence to the base of support (5);

-a film filter (9) which interferes with a narrow passing band which transmits in correspondence to the wave length, which corresponds to the solar energy threshold characteristic of the chosen photovoltaic cells. It is placed between disc (8) and the panel of photovoltaic cells (10);

These are common means which are foreseen for the cooling of modulus (1); of the panel of photovoltaic cells (10);

-10-

and of the semitransparent filter (9) connected with exter nal common means for the recovery and energetic transfor mation of the heat produced.

2) The solar modulus, according to claim 1, is characteri zed by the fact that support( 5) presents all its own inter nal surfaces 11 which reflect perfectly the radiations of almost all the band of solar light and of the emission band by thermic effect of disc (8.).

3) The solar modulus, according to claims 1 and 2, is cha racterized by the fact that, in support (5) a forced vacuum is present.

4) The solar modulus, according to claims 1,2 and 3, is characterized by the fact that the transparent opening (7) presents an externally hollow hemispherical form, so as to diminish the reflection of the concentrated radiation (4).

5) The solar modulus, according to claims 1,2,3 and 4, is characterized by the fact that the flat disc (8) is made up of a thin and continuous sheet.

6) The solar modulus, according to the claims 1,2,3,4 and 5, is characterized by the fact that disc( 8) is solidly and peripherically connected with the internal walls (11) of support (5) through means of a thermoisolated support.

7) The solar modulus, according to claims 1,2,3,4 and 5, is characterized by the fact that ,in the absence, in the solar modulus, of panel (10) of photovoltaic cells and of filter (9, the flat disc (8) is connec-ted, in its inferior part, to a tubular coil, inside of which circulates a thermo vector fluid which communicates on the exterior part of

-11-

the solar modulus, by means of two closed airtight open
ings, so that the thermovector fluid con enter the solar
modulus, circulate, in contact with disc (8), and leave
the modulus.

8) The solar modulus, according to claims 1,2,3,4,5 and
7 , is characterized by the fact that in the absence, in
the solar modulus, of panel(10)of photovoltaic cells and
of filter( 9),all the internal surfaces of support( 5)reflect
perfectly the radiations of almost the entire band of so
lar light of the emission band by thermic effect of disc
(8.

9) The highly yielding solar modulus for the transforma
tion, on photovoltaic cells, of a substantially monochro
matic radiation, according to the preceding claims and
to what has been described and illustrated for the spe
cific aims.

0116521

FIG. 1

FIG. 2